(19)

Europäisches
Patentamt
European
Patent Office
Office européen
des brevets

(11)  **EP 2 770 536 A1**

(12)  **EUROPEAN PATENT APPLICATION**

(43) Date of publication:
**27.08.2014  Bulletin 2014/35**

(51) Int Cl.:
**H01L 29/417** (2006.01)     **H01L 29/786** (2006.01)

(21) Application number: **13169952.2**

(22) Date of filing: **31.05.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.02.2013  KR 20130018737**

(71) Applicant: **Samsung Display Co., Ltd.
Gyeonggi-Do (KR)**

(72) Inventors:
• **Park, Seung Hyun
  Seoul 3-107 (KR)**
• **Song, Jun Ho
  Seongnam-si, Gyeonggi-do 101-601 (KR)**
• **Lee, Jae Hak
  Suwon-si, Gyeonggi-do 2305-1702 (KR)**

(74) Representative: **Dr. Weitzel & Partner
Patent- und Rechtsanwälte mbB
Friedenstrasse 10
89522 Heidenheim (DE)**

(54)    **Thin film transistor and manufacturing method thereof**

(57)    A thin film transistor, includes: a gate electrode; a gate insulating layer disposed on the gate electrode; a semiconductor disposed on the gate insulating layer; an etch stopper disposed on a channel of the semiconductor; a source electrode disposed on the semiconductor; and a drain electrode disposed on the semiconductor. At least one of the source electrode and the drain electrode does not overlap with the etch stopper. At least one dimension of the etch stopper and the channel of the semiconductor are substantially the same.

FIG.3

**Description**

BACKGROUND

FIELD

Exemplary embodiments relate to thin film transistor technology, and more particularly to, a thin film transistor including an etch stopper and a manufacturing method thereof.

DISCUSSION

Electric elements, such as resistors, capacitors, diodes, inductors, and thin film transistors, are utilized in various fields. Among these electric elements, thin film transistors (TFT) are often used as switching and driving elements in consumer electronic devices, such as, for instance, a flat panel display, e.g., a liquid crystal display (LCD), an organic light emitting device (organic light emitting diode display (OLED)), a plasma display (PD), an electrophoretic display (EPD), an electrowetting display (EWD), and the like.

In conventional TFTs, a semiconductor portion usually governs the characteristics thereof. Typically, silicon (Si) is used as the semiconductor portion. The Si-based semiconductors may be divided into two general crystallization types, e.g., amorphous Si and polysilicon-based semiconductor types. Formation of amorphous Si semiconductors is relatively simple, but they generally have low charge mobility. As such, it is difficult to manufacture a high performance TFT using amorphous Si. Polysilicon semiconductors have higher charge mobility, but a process to crystallize the silicon is complex and less cost effective. Accordingly, oxide semiconductors using lost-cost metal oxide having relatively high uniformity as compared to polycrystalline Si, as well as relatively high charge mobility and a relatively high ON/OFF current ratio as compared to amorphous Si, are of interest.

To prevent a channel region of TFTs from being damaged by an etchant used in subsequent processing steps and to prevent an impurity, such as hydrogen (H), from being diffused in the manufacturing process of the TFTs, an etch stopper covering the channel region of the semiconductor may be used. The source electrode and the drain electrode of the TFT are typically disposed on at least a portion of the etch stopper, and, thereby, overlap with the etch stopper. In this manner, when the resolution of a light exposer used to form the pattern is considered, limits may exist in reducing minimum separation intervals between source electrodes and drain electrodes that overlap with at least a portion of the etch stopper and minimum lengths for areas overlapping with at least a portion of the etch stopper. For example, if the minimum feature size of an exposure apparatus is about 3 to 4 $\mu$m and the overlapping length between the source electrode and the drain electrode with the etch stopper is 2.5 $\mu$m, the minimum channel length of a corresponding thin film transistor would be about 8 to 9 $\mu$m. As previously described, if a minimum channel length exists due to limitations of the exposure equipment to fabricate TFTs, then a limitation in reducing the size of the TFTs also exists.

Therefore, there is a need for an approach that provides efficient, cost-effective techniques to reduce the channel dimensions of a TFT including an etch stopper, and, thereby, the overall size of the TFT.

The above information disclosed in this Background section is only for enhancement of understanding of the background of the invention, and, therefore, it may contain information that does not form the prior art that is already known in this country to a person of ordinary skill in the art.

SUMMARY

Exemplary embodiments may enable reductions the in channel dimensions (e.g., width, length, etc.) of a thin film transistor including an etch stopper, which may also reduce the size of the thin film transistor.

Exemplary embodiments provide a manufacturing method to fabricate the thin film transistor including the etch stopper.

Additional aspects will be set forth in the detailed description which follows and, in part, will be apparent from the disclosure, or may be learned by practice of the invention.

According to exemplary embodiments, a thin film transistor, includes: a gate electrode; a gate insulating layer disposed on the gate electrode; a semiconductor disposed on the gate insulating layer; an etch stopper disposed on a channel of the semiconductor; a source electrode disposed on the semiconductor; and a drain electrode disposed on the semiconductor. At least one of the source electrode and the drain electrode does not overlap with the etch stopper. At least one dimension of the etch stopper and a channel of the semiconductor are substantially the same.

According to exemplary embodiments, a thin film transistor, includes: a gate electrode; a gate insulating layer disposed on the gate electrode; a semiconductor disposed on the gate insulating layer; an etch stopper disposed on a channel of the semiconductor; a source electrode disposed on the semiconductor; a drain electrode disposed on the semiconductor; and a conductive layer disposed directly on a first portion of the semiconductor that is not covered by the etch stopper. The conductive layer is electrically connected to the source electrode or the drain electrode. At least one dimension of the etch stopper and the channel of the semiconductor are substantially the same.

According to exemplary embodiments, a method of manufacturing a thin film transistor, includes: forming a gate electrode on a substrate; forming a gate insulating layer on the gate electrode; forming a semiconductor on the gate insulating layer; forming an etch stopper on a channel of the semiconductor; forming a source electrode on the semiconductor; and forming a drain electrode on the semiconductor. At least one of the source electrode and the drain electrode does not overlap with the etch stopper. At least one dimension of the etch stopper and the channel of the semiconductor are substantially the same.

According to exemplary embodiments, a method of manufacturing a thin film transistor, includes: forming a gate electrode on a substrate; forming a gate insulating layer on the gate electrode; forming a semiconductor on the gate insulating layer; forming an etch stopper on a channel of the semiconductor; forming a conductive layer disposed directly on a portion of the semiconductor not covered by the etch stopper, the portion of the conductive layer being electrically connected to a source electrode or a drain electrode; forming the source electrode on the semiconductor; and forming the drain electrode on the semiconductor.

According to exemplary embodiments, a channel length of a thin film transistor including an etch stopper may be reduced, which may also reduce the size of the thin film transistor.

The foregoing general description and the following detailed description are exemplary and explanatory and are intended to provide further explanation of the invention as claimed.

BRIEF DESCRIPTION OF THE DRAWINGS

The accompanying drawings, which are included to provide a further understanding of the invention and are incorporated in and constitute a part of this specification, illustrate exemplary embodiments of the invention, and together with the description serve to explain the principles of the invention.

FIG. 1 is a plan view of a thin film transistor array panel including a thin film transistor, according to exemplary embodiments.

FIG. 2 is a cross-sectional view of the thin film transistor array panel of FIG. 1 taken along sectional line II-II, according to exemplary embodiments.

FIGS. 3-9 are illustrative cross-sectional views of a thin film transistor array panel including a thin film transistor, according to exemplary embodiments.

FIGS. 10-12 are respective plan views of a thin film transistor array panel including a thin film transistor, according to exemplary embodiments.

FIGS. 13-17 are respective cross-sectional views of a thin film transistor array panel including a thin film transistor at various manufacturing stages, according to exemplary embodiments.

FIGS. 18-22 are respective cross-sectional views of a thin film transistor array panel including a thin film transistor at various manufacturing stages, according to exemplary embodiments.

FIGS. 23-26 are respective cross-sectional views of a thin film transistor array panel including a thin film transistor at various manufacturing stages, according to exemplary embodiments.

FIGS. 27-30 are respective cross-sectional views of a thin film transistor array panel including a thin film transistor at various manufacturing stages, according to exemplary embodiments.

DETAILED DESCRIPTION OF THE ILLUSTRATED EMBODIMENTS

In the following description, for the purposes of explanation, numerous specific details are set forth in order to provide a thorough understanding of various exemplary embodiments. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments.

In the accompanying figures, the size and relative sizes of layers, films, panels, regions, etc., may be exaggerated for clarity and descriptive purposes. Also, like reference numerals denote like elements.

When an element or layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. Like numbers refer to like elements throughout. As used herein, the term "and/or" includes any and all combinations of one or more of the associated listed items.

Although the terms first, second, etc. may be used herein to describe various elements, components, regions, layers and/or sections, these elements, components, regions, layers and/or sections should not be limited by these terms. These terms are used to distinguish one element, component, region, layer or section from another region, layer or section. Thus, a first element, component, region, layer or section discussed below could be termed a second element, component, region, layer or section without departing from the teachings of the present disclosure.

Spatially relative terms, such as "beneath," "below," "lower," "above," "upper," and/or the like, may be used herein for descriptive purposes, and thereby, to describe one element or feature's relationship to another element(s) or feature(s) as illustrated in the drawings. Spatially relative terms are intended to encompass different orientations of an apparatus in use or operation in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and as such, the spatially relative descriptors used herein interpreted accordingly.

The terminology used herein is for the purpose of describing particular embodiments and is not intended to be limiting. As used herein, the singular forms "a," "an," and "the" are intended to include the plural forms as well, unless the context clearly indicates otherwise. Moreover, the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Various exemplary embodiments are described herein with reference to sectional illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not be construed as limited to the particular illustrated shapes of regions, but are to include deviations in shapes that result from, for instance, manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and will not be interpreted in an idealized or overly formal sense, unless expressly so defined herein.

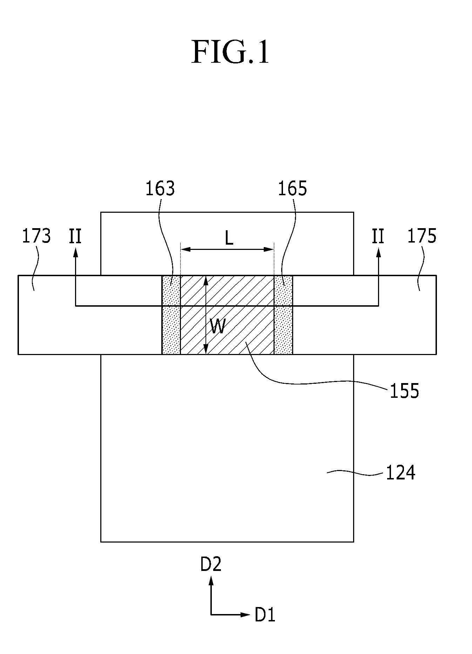

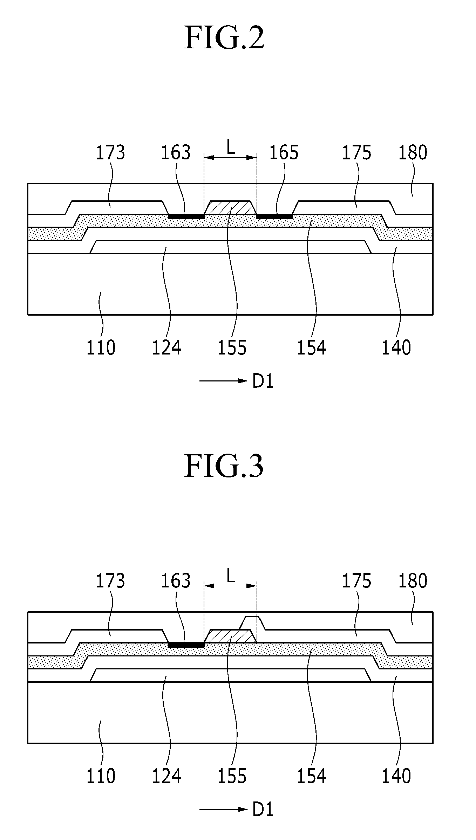

An exemplary thin film transistor array panel including a thin film transistor will now be described with reference to FIGS. 1 and 2.

FIG. 1 is a plan view of a thin film transistor array panel including a thin film transistor, according to exemplary embodiments. FIG. 2 is a cross-sectional view of the thin film transistor array panel of FIG. 1 taken along sectional line II-II.

Referring to FIG. 1, a gate electrode 124 is disposed on a substrate 110 including an insulating material, such as plastic, glass, etc. The gate electrode 124 may be made of any suitable material, such as, for instance, an aluminum-based metal, e.g., aluminum (Al) or an Al alloy, a silver-based metal, e.g., silver (Ag) or a Ag alloy, a copper-based metal, e.g., copper (Cu) or a Cu alloy, a molybdenum-based metal, e.g., molybdenum (Mo) or a Mo alloy, a chromium-based metal, e.g., chromium (Cr) or a Cr alloy, a tantalum-based metal, e.g., tantalum (Ta) or a Ta alloy, a titanium-based metal, e.g., titanium (Ti) or a Ti alloy, and/or the like. It is contemplated that the gate electrode 124 may include a multilayered structure, e.g., including at least two conductive layers of different physical properties. For example, the gate electrode 124 may be a multilayered structure, such as, for instance, Mo/Al/Mo, Mo/Al, Mo/Cu, CuMn/Cu, and Ti/Cu.

A gate insulating layer 140 is disposed on the gate electrode 124. The gate insulating layer 140 may include any suitable insulating material, such as, for example, silicon oxide (SiOx), silicon nitride (SiNx), silicon oxynitride (SiON), etc. The gate insulating layer 140 may be formed via any suitable method, e.g., a sputtering method.

A semiconductor 154 is disposed on the gate insulating layer 140. The semiconductor 154 may include polysilicon or an oxide semiconductor. As a metal oxide semiconductor, the oxide semiconductor may be formed of any suitable oxide of any suitable metal, such as, for example, zinc (Zn), indium (In), gallium (Ga), tin (Sn), Ti, or the like, or a combination of any suitable metals, such as Zn, In, Ga, Sn, Ti, and the like, and oxides thereof.

A source electrode 173 and a drain electrode 175 are disposed on the semiconductor 154. The source electrode 173 and the drain electrode 175 may directly contact the semiconductor 154, and face each other with respect to the gate electrode 124. According to exemplary embodiments, the semiconductor 154 may be an island type. Further, the semiconductor 154 (except for a separation portion between the source electrode 173 and the drain electrode 175) may have substantially the same plane shape as the source electrode 173 and the drain electrode 175. The plane shape refers to a shape of the component in a plan view of the substrate 110. FIGS. 1 and 2 show an example in which the semiconductor 154 (except for the separation portion between the source electrode 173 and the drain electrode 175), and the source electrode 173 and the drain electrode 175, have substantially the same plane shapes. In this manner, the source electrode 173, the drain electrode 175, and the semiconductor 154 may be formed via any suitable technique, such as, for example, an exposure process using a photomask (or reticle) including a halftone region; however, any other suitable type of photomask may be utilized, e.g., binary, alternating phase shifting material, optical proximity correction, etc.

The source electrode 173 and the drain electrode 175 may be made of any suitable, conductive material, e.g., an Al-based metal, an Ag-based metal, a Cu-based metal, a Mo-based metal, a Cr-based metal, a Ta-based metal, a Ti-based metal, and/or the like. For example, a Mo alloy may include Mo-niobium (Nb) and Mo-Ti. It is also contemplated that the source electrode 173 and the drain electrode 175 may be made of a transparent conductive material, such as, for example, indium tin oxide (ITO), indium zinc oxide (IZO), aluminum zinc oxide (AZO), gallium zinc oxide (GZO), etc. It is also contemplated that one or more conductive polymers (ICP) may be utilized, such as, for example, polyaniline, poly(3,4-ethylenedioxythiophene) poly(styrenesulfonate) (PEDOT:PSS), etc. The source electrode 173 and the drain electrode 175 may be multilayered structures including two or more conductive layers (not illustrated). For example, the source electrode 173 and the drain electrode 175 may be multilayered structures, such as Mo/Al/Mo, Mo/Al, Mo/Cu, CuMn/Cu, and Ti/Cu.

According to exemplary embodiments, an etch stopper (referred to as an etch preventing layer) 155 is disposed on the semiconductor 154. A passivation layer 180 is disposed on the etch stopper 155.

In exemplary embodiments, the etch stopper 155 covers the channel of the semiconductor 154, thereby, preventing the channel of the TFT from being damaged or contaminated (or otherwise changed) by an etch gas or an etchant used in subsequent processing steps, such as, for example, an etching process of the source electrode 173 and the drain electrode 175. Also, the etch stopper 155 may prevent an impurity, such as hydrogen, from being diffused from the insulating layer (e.g., the passivation layer 180) disposed on the semiconductor 154 into the semiconductor 154. A thickness of the etch stopper 155 may be less than about 3000 Å. The etch stopper 155 may be generally made of SiOx. It is contemplated, however, that the etch stopper 155 may be made of any suitable inorganic material including at least one material of SiOx, SiNx, SiOC, and SiON, any suitable organic material, any suitable organic polymer material, etc.

According to exemplary embodiments, at least one of the source electrode 173 and the drain electrode 175 may not overlap with at least a portion of the etch stopper 155. Alternatively, both the source electrode 173 and the drain electrode 175 may at least partially overlap with the etch stopper 155. That is, the etch stopper 155 may be disposed on the semiconductor 154 disposed in a separation space between the source electrode 173 and the drain electrode 175, such that it may not contact at least one of the source electrode 173 and the drain electrode 175, and may overlap with the source electrode 173 and the drain electrode 175, and, thereby, may contact at least one of the source electrode 173 and the drain electrode 175. FIGS. 1 and 2 show an example of the source electrode 173 and the drain electrode 175 not overlapping with at least a portion of the etch stopper 155.

In exemplary embodiments, the source electrode 173 or the drain electrode 175 and the etch stopper 155 may be separated from each other, as shown in FIGS. 1 and 2. As such, the surface portion of the semiconductor 154 disposed between the etch stopper 155 and the source electrode 173 or the drain electrode 175 forms conductive layers 163 and 165 having conductivity. The surface portion of the semiconductor 154 refers to a portion of a side of the semiconductor that contacts the source electrode 173 and the drain electrode 175 among the sides of the semiconductor 154. The conductive layers 163 and 165 are physically and electrically connected to the source electrode 173 or the drain electrode 175. As such, the conductive layers 163 and 165 may extend under at least a portion of the source electrode 173 and the drain electrode 175. In other words, the source electrode 173 and the drain electrode 175 may be disposed on at least a portion of the conductive layers 163 and 165. Accordingly, the source electrode 173 and the conductive layer 163 connected thereto together substantially form a source electrode, and the drain electrode 175 and the conductive layer 163 connected thereto together substantially form a drain electrode. As such, the channel of the TFT may be formed in the semiconductor 154 between the conductive layers 163 and 165 with respect to the gate electrode 124.

Accordingly, a channel length L of the TFT may be about the same as the width of the etch stopper 155 and the length of the etch stopper 155 in a first (e.g., horizontal) direction D1. The width of the etch stopper 155 in the first direction D1 may refer to the shortest distance between the source electrode 173 and the drain electrode 175. It is noted that the terms "length" and "width" are utilized merely for descriptive purposes, and, thereby, are not utilized to narrow the scope of the corresponding dimensions associated with the etch stopper 155 and the channel of the TFT. In this manner, the terms "length" and "width" may be used interchangeably to relate to the corresponding dimension(s) described herein.

The passivation layer 180 may include any suitable material, such as, for example, an inorganic material, e.g., SiOx, SiNx, SiON, etc., an organic material, and/or the like.

As previously described, according to exemplary embodiments, the source electrode 173 and the drain electrode 175 may not overlap with at least a portion of the etch stopper 155, such that the overlapping area may not be considered. As a result, the length of the etch stopper 155 in the horizontal direction D1 may be reduced to the minimum feature size of an exposure apparatus utilized to form the TFT. Also, according to exemplary embodiments, the channel length L of the thin film transistor may be determined based on the length of the etch stopper 155 in the horizontal direction D1, such that the channel length L may also be reduced to the minimum feature size of the exposure apparatus. For example, when the minimum feature size of the exposure apparatus is about 3 $\mu$m, the length of the etch stopper 155 in the horizontal direction D1 may be reduced to 3 $\mu$m. In this manner, the channel length L of the TFT may be reduced to about 3 $\mu$m. To this end, exemplary embodiments scale with the minimum feature sizes of the exposure devices. Minimum feature size may be approximated based on Equation 1, shown below:

$$CD = k_1 * (\lambda / NA) \hspace{5cm} \text{Equation (1)}$$

where,

CD = minimum feature size;
$k_1$ = k1 factor (or coefficient encapsulating process-related factors);
$\lambda$ = wavelength of exposure light; and
NA = numerical aperture of lens of exposure apparatus.

Referring to FIG. 1, the channel width W of the TFT, according to exemplary embodiments, may refer to the length of the channel in a second (or vertical) direction D2 in the overlapping region where the semiconductor 154 and the etch stopper 155 overlap one another. The second direction D2 is substantially perpendicular to the first direction D1. In exemplary embodiments, the etch stopper 155 may be disposed in a region bounded by the semiconductor 154. As such, the channel width W of the TFT may be substantially the same as the width the etch stopper 155 in the second direction D2. In this manner, the etch stopper 155 and the semiconductor 154 may be formed through an exposure process using the same photomask including, for instance, a halftone region. Again, any other suitable photomask may be utilized. Alternatively, the upper and/or lower portions of the etch stopper 155 may extend from the region bounded by the semiconductor 154.

According to exemplary embodiments, the conductive layers 163 and 165 may be formed after forming the etch stopper 155, the source electrode 173, and the drain electrode 175. For instance, when the semiconductor 154 includes the oxide semiconductor, a separate plasma treatment may be performed to form the exposed portion of the semiconductor 154 after the source electrode 173 and the drain electrode 175 are formed and before the passivation layer 180 is formed. In this manner, the conductive layers 163 and 165 may be formed. When, for instance, the semiconductor 154 includes the oxide semiconductor and the passivation layer 180 is formed via plasma enhanced chemical vapor deposition (PECVD), the exposed semiconductor 154 may be doped with an impurity when the passivation layer 180 is being formed and transited into a conductor, which, thereby, forms the conductive layers 163 and 165. Alternatively, when the semiconductor 154 includes polysilicon, the exposed portion of the semiconductor 154 may be doped with an n-type impurity, such as phosphorous (P), or a p-type impurity, and may be performed via annealing before the passivation layer 180 is formed, but after the source electrode 173 and the drain electrode 175 are formed. In this manner, the conductive layers 163 and 165 may be formed.

With continued reference to FIGS. 1 and 2, several examples of TFT array panels including exemplary TFTs will be described with reference to FIGS. 3-9. In order to avoid obscuring exemplary embodiments described herein duplicative descriptions are omitted.

FIGS. 3-9 are illustrative cross-sectional views of a thin film transistor array panel including a thin film transistor, according to exemplary embodiments.

Referring to FIG. 3, the TFT is substantially the same as the TFT shown in FIGS. 1 and 2; however, in FIG. 3, the source electrode 173 does not overlap with at least a portion of the etch stopper 155 and the drain electrode 175 overlaps with at least a portion of the etch stopper 155. The size (or extent) of the region where the drain electrode 175 overlaps with at least a portion of the etch stopper 155 may be any suitable amount.

The source electrode 173 and the etch stopper 155 may be separated from each other, as shown in FIG. 3. In this manner, the surface portion of the semiconductor 154 disposed between the etch stopper 155 and the source electrode 173 forms the conductive layer 163 having conductivity. In this manner, the TFT of FIG. 3 does not include conductive layer 165. The conductive layer 163 and the formation method thereof are substantially the same as previously described, and, therefore, a corresponding detailed description is omitted. In exemplary embodiments, the channel length L of the TFT is substantially the same as the length of the etch stopper 155 in the first direction D1, and the channel length L of the TFT may be reduced to the minimum feature size of the exposure apparatus, which, thereby, reduces the size of the TFT. In contrast to FIG. 3, the drain electrode 175 may not overlap with at least a portion of the etch stopper 155, such that the source electrode 173 may overlap with at least a portion of the etch stopper 155.

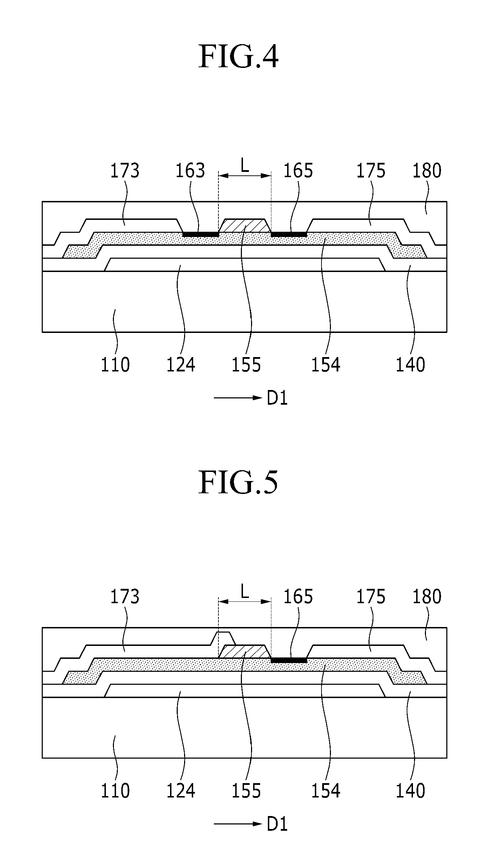

As seen in FIG. 4, the TFT is substantially the same as the TFT shown in FIGS. 1 and 2; however, the semiconductor 154 in FIG. 4 is an island-type semiconductor instead of having substantially the same plane shape as the source electrode 173 and the drain electrode 175. In this manner, the source electrode 173, the drain electrode 175, and the semiconductor 154 may be formed through multiple exposure processes using different photomasks.

Adverting to FIG. 5, the TFT is substantially the same as the TFT shown in FIGS. 1 and 2; however, the semiconductor 154 of FIG. 5 is an island-type instead of having substantially the same plane shape as the source electrode 173 and the drain electrode 175. To this end, the drain electrode 175 does not overlap with at least a portion of the etch stopper 155, and the source electrode 173 overlaps with at least a portion the etch stopper 155.

Furthermore, as shown in FIG. 5, the drain electrode 175 and the etch stopper 155 are separated from each other. In this manner, the surface portion of the semiconductor 154 disposed between the etch stopper 155 and the drain electrode 175 forms the conductive layer 165 having conductivity. In contrast to FIG. 4, the source electrode 173 may not overlap with at least a portion of the etch stopper 155, and the drain electrode 175 may overlap with at least a portion of the etch stopper 155.

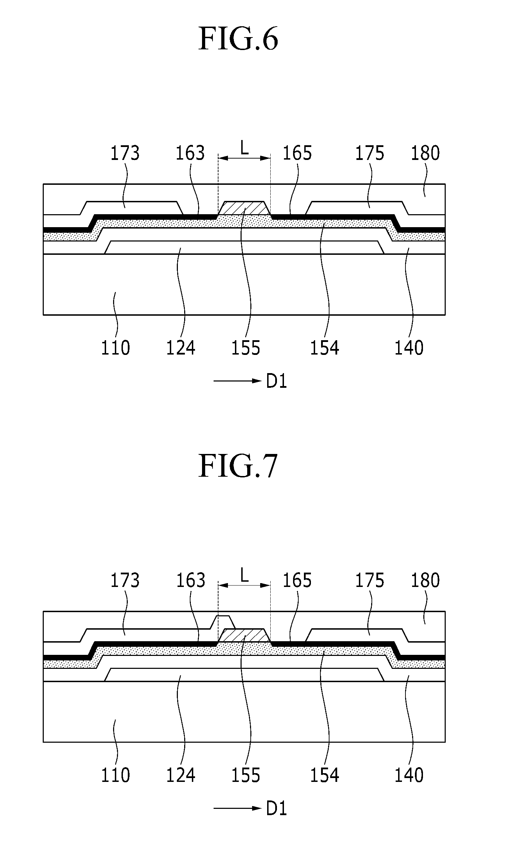

Referring to FIG. 6, the TFT is substantially the same as the TFT shown in FIGS. 1 and 2; however, the conductive layers 163 and 165 in FIG. 6 are formed at the surface of the semiconductor 154 overlapping with the source electrode 173 and the drain electrode 175, as well as the surface of the semiconductor 154 disposed between the etch stopper 155 and the source electrode 173 and the drain electrode 175. In this manner, the entire surface portion of the semiconductor 154 that is not covered by the etch stopper 155 may form a portion of the conductive layers 163 and 165.

The conductive layers 163 and 165, according to exemplary embodiments, may be formed after forming the etch stopper 155, which may be formed after forming the source electrode 173 and the drain electrode 175. For instance, when the semiconductor 154 includes the oxide semiconductor, the portion of the semiconductor 154 that is not covered by the etch stopper 155 and is exposed may undergo plasma treatment, which forms the conductive layers 163 and 165. Alternatively, when the semiconductor 154 includes a polysilicon material, the portion of the semiconductor 154 that is not covered by the etch stopper 155 and is exposed, may be doped with an impurity, such as P, and may be annealed, which forms the conductive layers 163 and 165.

According to exemplary embodiments, the channel length L of the TFT is substantially the same as the length of the etch stopper 155 in the horizontal direction D1, and the channel length L of the TFT may be reduced to the minimum feature size of the exposure apparatus, which, thereby, reduces the size of the TFT.

As seen in FIG. 7, the TFT is substantially the same as the TFT shown in FIG. 6; however, the drain electrode 175 in FIG. 7 does not overlap the etch stopper 155, whereas the source electrode 173 does overlap the etch stopper 155. Further, the drain electrode 175 and the etch stopper 155 may be separated from each other. In this manner, the conductive layer 165 disposed between the etch stopper 155 and the drain electrode 175 is not covered by the drain electrode 175 and, thereby, is exposed to passivation layer 180. In contrast to FIG. 7, and while not illustrated, the source electrode 173 may be configured to not overlap the etch stopper 155, whereas the drain electrode 175 may be configured to overlap the etch stopper 155.

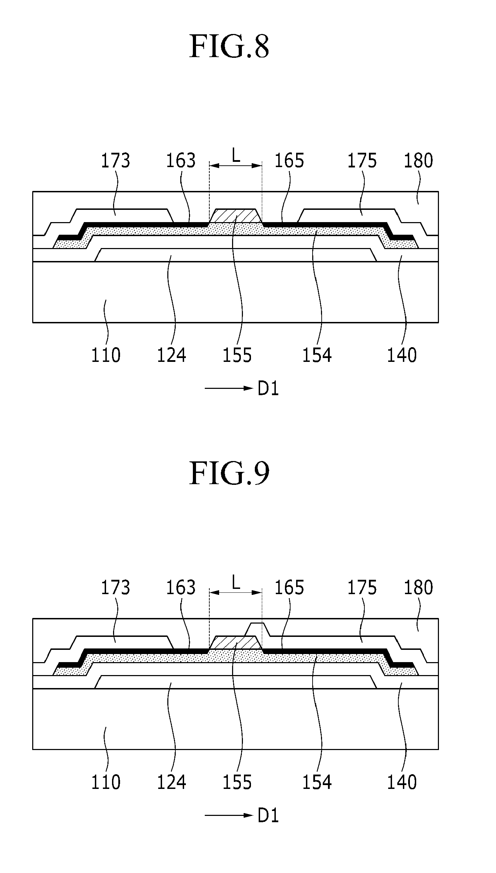

Adverting to FIG. 8, the TFT is substantially the same as the TFT shown in FIG. 6; however, the semiconductor 154 in FIG. 8 is an island-type instead of having substantially the same plane shape as the source electrode 173 and the drain electrode 175. As seen in FIG. 8, neither of the source electrode 173 and the drain electrode 174 overlap the etch stopper 155.

Referring to FIG. 9, the TFT is substantially the same as the TFT shown in FIG. 8; however, in FIG. 9, the source electrode 173 does not overlap the etch stopper 155, whereas the drain electrode 175 does overlap the etch stopper 155. Furthermore, the source electrode 173 and the etch stopper 155 may be separated from each other as shown in FIG. 9. In this manner, the conductive layer 163 disposed between the etch stopper 155 and the source electrode 173 may not be covered by the source electrode 173, and, therefore, may be exposed to passivation layer 180. In contrast to FIG. 9, and while not illustrated, the drain electrode 175 may not overlap the etch stopper 155, whereas the source electrode 173 may overlap the etch stopper 155.

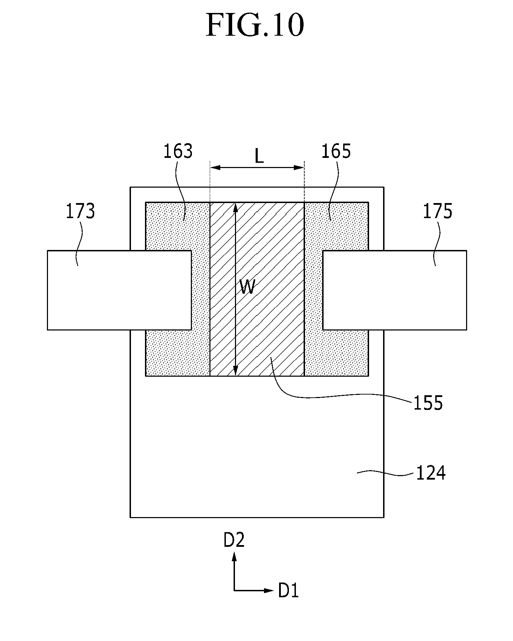

With continued reference to FIGS. 1-9, a TFT array panel including an exemplary TFT will be described with reference to FIGS. 10-12.

FIGS. 10-12 are respective plan views of a thin film transistor array panel including a thin film transistor, according to exemplary embodiments.

As seen in FIG. 10, the TFT array panel is substantially the same as the TFT array panel shown in FIGS. 1 and 2; however, the channel width W of the TFT in FIG. 10 is larger. In this manner, the corresponding widths of the semiconductor 154 and the conductive layers 163 and 165 may also be larger, and substantially the same as the channel width W.

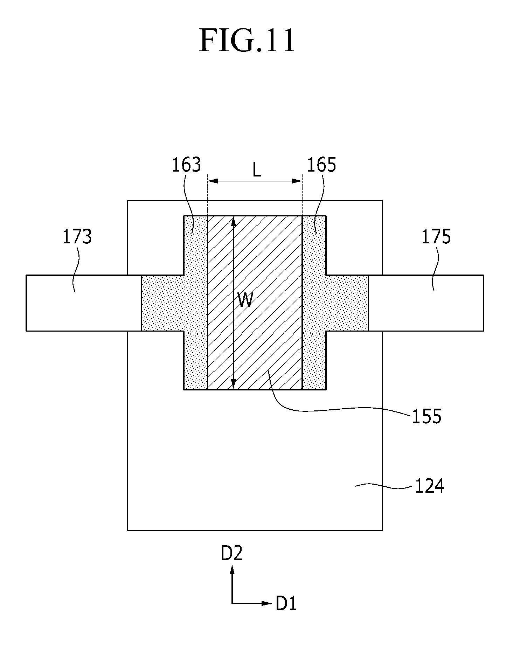

Referring to FIG. 11, the TFT is substantially the same as the TFT shown in FIG. 10; however, in FIG. 11, the respective areas of the conductive layers 163 and 165 that are not covered by the source electrode 173 and drain electrode 175 and the etch stopper 155 is smaller. For instance, the non-overlapped areas of the respective conductive layers 163 and 165 may form sideways T shapes.

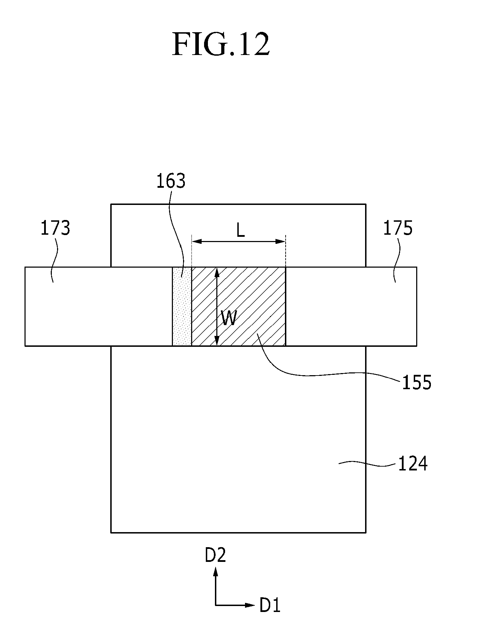

Adverting to FIG. 12, the TFT is substantially the same as the TFT shown in FIGS. 1 and 2; however, in FIG.

12, the source electrode 173 does not overlap the etch stopper 155, whereas the drain electrode 175 contacts and/or overlaps the etch stopper 155. For instance, similar to as shown in FIG. 3, the source electrode 173 and the etch stopper 155 may be separate from each other, such that the surface portion of the semiconductor 154 disposed between the etch stopper 155 and the source electrode 173 forms the conductive layer 163 having conductivity.

According to exemplary embodiments, it is contemplated that the plane shape of the source electrode 173, the drain electrode 175, the semiconductor 154, and the etch stopper 155 may be changed in any suitable matter, and may not correspond to one or more of the other ones of the source electrode 173, the drain electrode 175, the semiconductor 154, and the etch stopper 155.

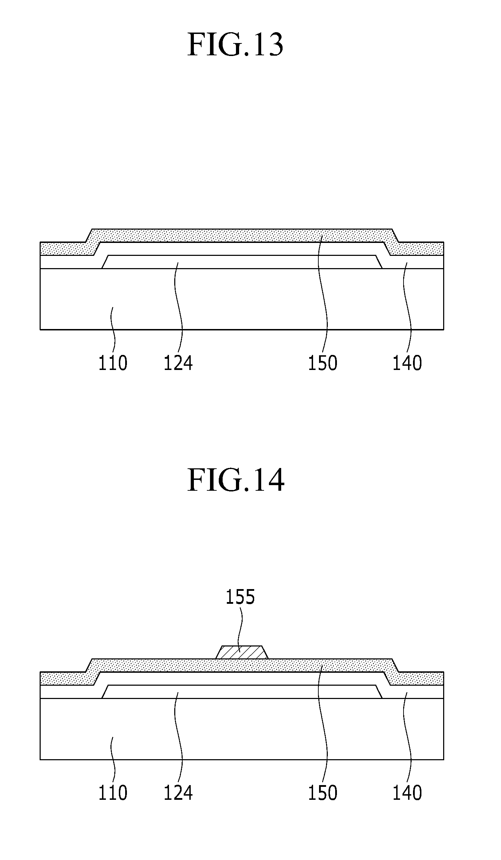

With continued reference to FIGS. 1-12, a manufacturing method to fabricate a TFT array panel including an exemplary TFT will be now described with reference to FIGS. 13-17.

FIGS. 13-17 are respective cross-sectional views of a thin film transistor array panel including a thin film transistor at various manufacturing stages, according to exemplary embodiments.

Referring to FIG. 13, a conductive material, such as a conductive metal material, is deposited on a substrate 110, which may include any suitable insulating material, such as, for instance, plastic, glass, etc. In this manner, the deposited conductive material is patterned to form a gate electrode 124.

An insulating material, such as, for instance, SiOx, SiNx, SiON, etc., is deposited on the gate electrode 124 to form a gate insulating layer 140. A polysilicon or oxide semiconductor material is deposited on the gate insulating layer 140 to form a semiconductor layer 150.

Adverting to FIG. 14, an inorganic material, such as, for example, SiOx, SiNx, SiOC, SiON, or an organic material, is deposited on the semiconductor layer 150 via any suitable process, e.g., via chemical vapor deposition. In this manner, the layer deposited on the semiconductor layer 150 is patterned to form an etch stopper 155. In the chemical vapor deposition process, a gas may be selected so that the characteristics of the portion of the semiconductor 154 covered by the etch stopper 155 are not altered. The thickness of the etch stopper 155 may be formed less than about 3000 Å, such as about 1000 Å to about 1500 Å.

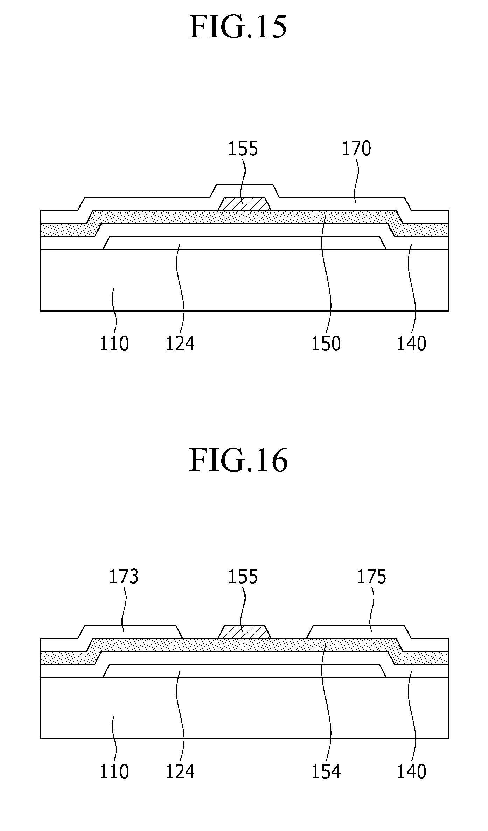

As seen in FIG. 15, a conductive material, such as a conductive metal material, is deposited on the etch stopper 155 and the semiconductor layer 150 to form a conductor layer 170. It is contemplated that the conductive material of the conductor layer 170 may be the same as or different from the conductive material utilized in association with the gate electrode 124.

Referring to FIG. 16, a photosensitive film (not shown) is coated on the conductor layer 170 and exposed using a photomask including a halftone region (or any other suitable formation) to form a photosensitive film pattern (not illustrated). In this manner, the conductor layer 170 and the semiconductor layer 150 are etched to form a semiconductor 154. At this time, the channel of the TFT may still be covered by the conductor layer 170. As such, the photosensitive film pattern (not shown) is ashed (or otherwise removed) to expose the conductor layer 170 on the channel of the TFT. In this manner, the conductor layer 170 is etched to form the source electrode 173 and the drain electrode 175, which face each other with respect to the channel of the TFT.

According to exemplary embodiments, the source electrode 173 and the drain electrode 175 may not overlap and/or may be separate from the etch stopper 155. It is contemplated, however, that at least one of the source electrode 173 and the drain electrode 175 may overlap the etch stopper 155.

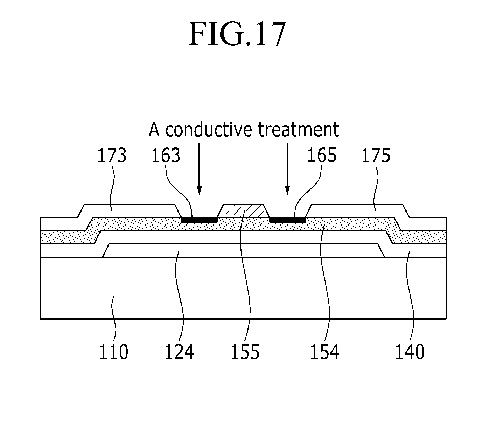

Adverting to FIG. 17, a conductive treatment is performed on the portion of the semiconductor 154 that is not covered by the source electrode 173, the drain electrode 175, and/or the etch stopper 155. In this manner, this (or these) portion(s) is exposed to form the conductive layers 163 and 165 having conductivity.

According to exemplary embodiments, when the semiconductor 154 includes the oxide semiconductor, the conductive treatment may include a plasma treatment. The plasma treatment may use a gas including at least one of hydrogen (H), boron (B), phosphorous (P), and nitrogen (N). For example, the plasma gas may include hydrogen gas ($H_2$), diborane ($B_2H_6$), phosphine ($PH_3$), nitrogen gas ($N_2$), oxygen gas ($O_2$), nitrous oxide ($N_2O$), nitrogen trifluoride ($NF_3$), ammonia gas ($NH_3$), ethane gas ($C_2H_6$), silane gas ($SiH_4$), etc. In this manner, the plasma treatment may entail any suitable process, such as, for instance, reactive-ion etching (RIE), enhanced capacitively coupled plasma (ECCP), inductively coupled plasma (ICP), plasma-enhanced chemical vapor deposition (PECVD), low-pressure chemical vapor deposition (LPCVD), and/or the like. Hydrogen (H), boron (B), phosphorus (P), and/or nitrogen (N) doped to the surface of the semiconductor 154 via the plasma treatment may operate as a donor, and, thereby, enable formation of the conductive layers 163 and 165.

In exemplary embodiments, when the semiconductor 154 includes a polysilicon material, the conductive treatment to form the conductive layers 163 and 165 may include doping and annealing processes of an n-type impurity or a p-type impurity according to, for instance, ion implantation. Any other suitable formation process, however, may be utilized to form the conductive layers 163 and 165.

As seen in FIG. 2, an inorganic or organic insulating material is deposited on the source electrode 173, the drain electrode 175, and the etch stopper 155 to form a passivation layer 180.

According to exemplary embodiments, the plasma treatment to form the conductive layers 163 and 165 may be separately performed before forming the passivation layer 180; however, the plasma treatment may be performed in association with the deposition process of the passivation layer 180. That is, elements of the plasma gas used when forming the passivation layer 180 via, for instance, PECVD, may be doped in the exposed portions of the semiconductor 154, to, thereby, form the conductive layers 163 and 165. For example, when forming the passivation layer 180 via depositing SiNx, a mixture gas of silane gas and ammonia gas may be used as a deposition gas. In this manner, protons induced in the silane gas may be doped into the semiconductor 154, to, thereby, form the conductive layers 163 and 165.

The formed conductive layers 163 and 165 are physically and electrically connected to the source electrode 173 or the drain electrode 175. As such, the conductive layers 163 and 165 may be extended under the source electrode 173 and the drain electrode 175, such as illustrated in association with FIGS. 6-9.

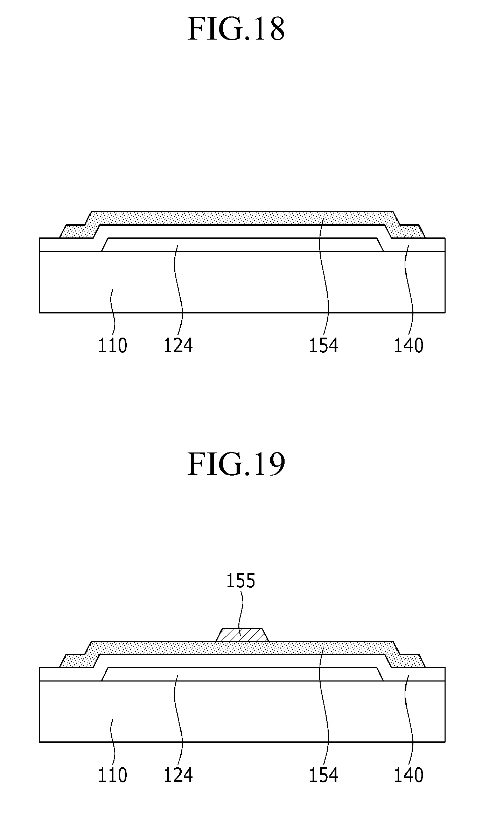

With continued reference to FIGS. 1-17, a manufacturing method to fabricate a TFT array panel including an exemplary TFT will now be described with reference to FIGS. 18-22.

FIGS. 18-22 are respective cross-sectional views of a thin film transistor array panel including a thin film transistor at various manufacturing stages, according to exemplary embodiments.

Referring to FIG. 18, after sequentially forming a gate electrode 124 and a gate insulating layer 140 on a substrate 110, a polysilicon or oxide semiconductor material is deposited to form a semiconductor layer 150, which is illustrated in FIG. 13. Next, the semiconductor layer 150 is patterned to form an island-type semiconductor 154, as seen in FIG. 18.

Adverting to FIG. 19, an inorganic material, such as, for instance, SiOx, SiNx, SiOC, SiON, etc., or an organic material is deposited on the semiconductor 154 via, for example, chemical vapor deposition. In this manner, the deposited layer is patterned to form an etch stopper 155.

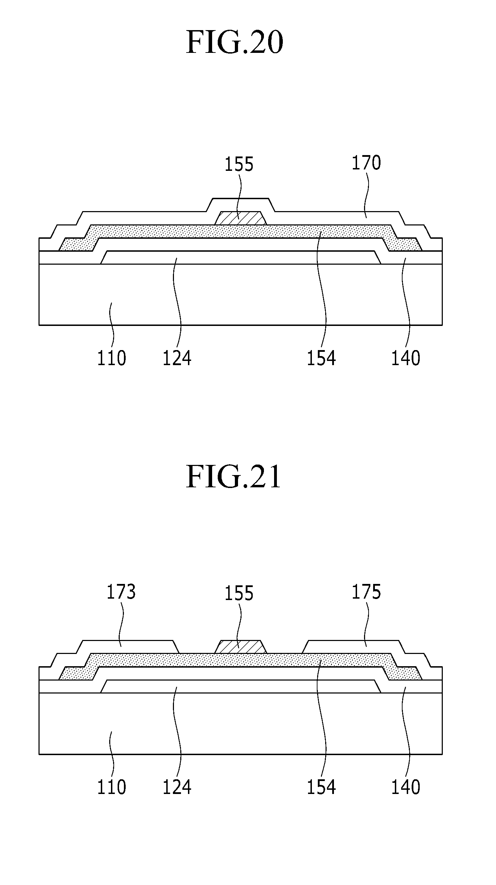

As seen in FIG. 20, a conductive material, such as a conductive metal material, is deposited on the etch stopper 155 and the semiconductor 154 to form a conductor layer 170.

With reference to FIG. 21, the conductor layer 170 is patterned to form a source electrode 173 and a drain electrode 175, which face each other with respect to the channel of the TFT.

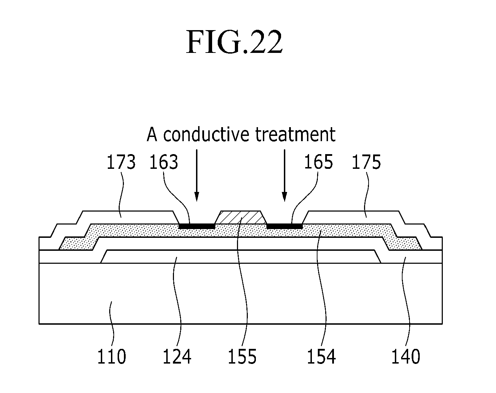

Referring to FIG. 22, a conductive treatment is performed in association with the portion of the semiconductor 154 that is not covered by the source electrode 173, the drain electrode 175, and/or the etch stopper 155. In this manner, the exposed portion forms the conductive layers 163 and 165 having conductivity. As previously described, when the semiconductor 154 includes the oxide semiconductor, the conductive treatment may include a plasma treatment. When the semiconductor 154 includes a polysilicon material, the conductive treatment to form the conductive layers 163 and 165 may include doping and annealing processes of an n-type impurity or a p-type impurity according to an ion implantation. Any other suitable formation process, however, may be utilized to form the conductive layers 163 and 165.

As seen in FIG. 4, an inorganic insulating material and/or an organic insulating material is deposited on the source electrode 173, the drain electrode 175, and the etch stopper 155 to form a passivation layer 180.

In exemplary embodiments, when the semiconductor 154 includes the oxide semiconductor, the conductive treatment to form the conductive layers 163 and 165 may be performed in association with a plasma treatment utilizing a deposition gas utilized in association with a deposition process to form the passivation layer 180.

According to exemplary embodiments, the source electrode 173 and the drain electrode 175 may not overlap and/or may be separated from the etch stopper 155. It is contemplated, however, that at least one of the source electrode 173 and drain electrode 175 may overlap the etch stopper 155.

With continued reference to FIGS. 1-12, a manufacturing method to fabricate a TFT array panel including an exemplary TFT will now be described with reference to xFIGS. 23-26.

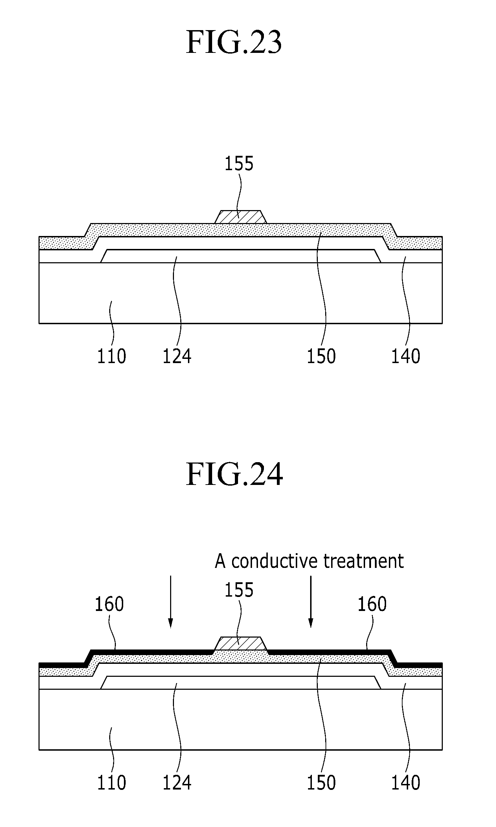

FIGS. 23-26 are respective cross-sectional views of a thin film transistor array panel including a thin film transistor at various manufacturing stages, according to exemplary embodiments.

Referring to FIG. 23, after sequentially forming a gate electrode 124 and a gate insulating layer 140 on a substrate 110, a polysilicon or oxide semiconductor material is deposited to form a semiconductor layer 150. An inorganic material, such as, for instance, SiOx, SiNx, SiOC, SiON, etc., or an organic material is deposited on the semiconductor 154 via, for example, chemical vapor deposition. In this manner, the deposited layer is patterned to form an etch stopper 155.

Adverting to FIG. 24, a conductive treatment is performed in association with the exposed surface of the semiconductor 154 that is not covered by the etch stopper 155. In this manner, the exposed surface subject to the conductive treatment forms a conductive layer 160 having conductivity. As previously described, when the semiconductor 154 includes an oxide semiconductor, the conductive treatment may include a plasma treatment. When the semiconductor 154 includes a polysilicon material, the conductive treatment to form the conductive layers 163 and 165 may include doping and annealing processes of an n-type impurity or a p-type impurity according to ion implantation. Any other suitable formation process, however, may be utilized to form the conductive layers 163 and 165.

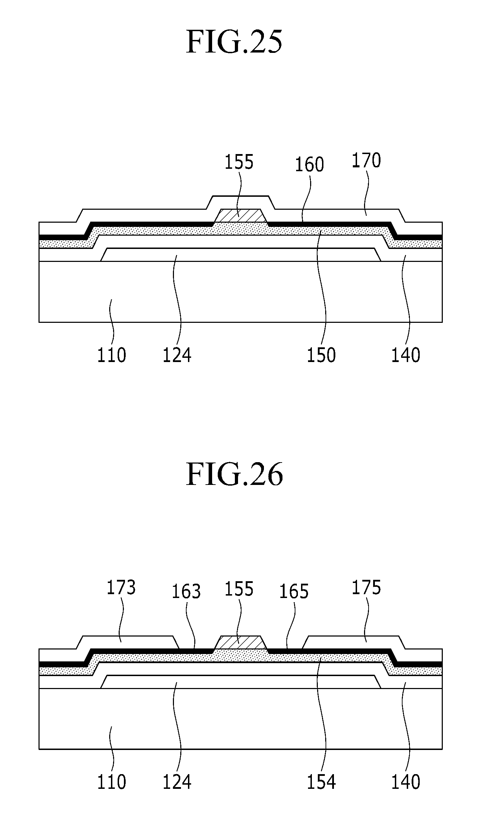

Referring to FIG. 25, a conductive material, such as a conductive metal material, is deposited on the conductive layer 160 and the etch stopper 155 to form the conductor layer 170.

As seen in FIG. 26, a photosensitive film (not shown) is coated on the conductor layer 170 and is exposed using a photomask including the halftone region (or any other suitable formation) to form a photosensitive film pattern (not illustrated). In this manner, the conductor layer 170, the conductive layer 160, and the semiconductor layer 150 may be patterned to form the semiconductor 154 and the conductive layers 163 and 165. At this time, the channel of the TFT may be covered by the conductor layer 170. As such, after ashing (or otherwise removing) the photosensitive film pattern to pattern a photosensitive film pattern to expose the channel of the TFT, the conductor layer 170 is etched to form the source electrode 173 and the drain electrode 175, which face each other with respect to the channel of the TFT.

According to exemplary embodiments, the source electrode 173 and the drain electrode 175 may not overlap and/or may be separate from the etch stopper 155. It is contemplated, however, that at least one of the source electrode 173 and the drain electrode 175 may overlap the etch stopper 155.

As seen in FIG. 6, an inorganic and/or organic insulating material is deposited on the source electrode 173, the drain electrode 175, and the etch stopper 155 to form a passivation layer 180.

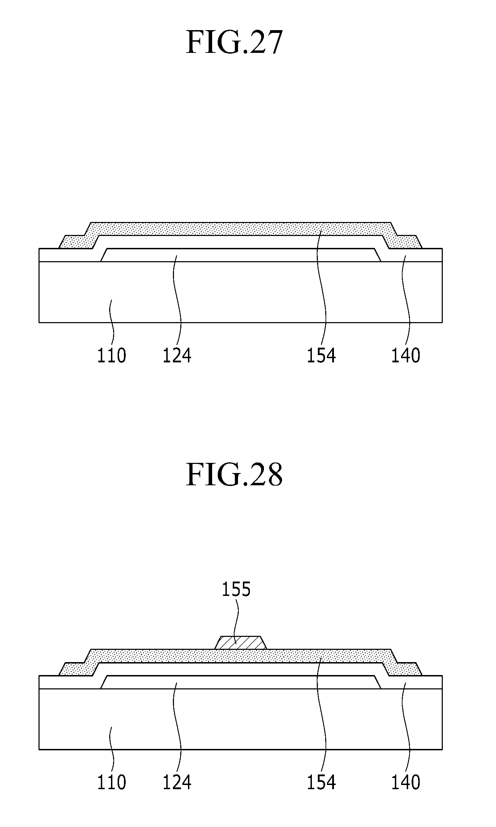

With continued reference to FIGS. 1-12, a manufacturing method to fabricate a TFT array panel including an exemplary TFT will now be described with reference to FIGS. 27-30.

FIGS. 27-30 are respective cross-sectional views of a thin film transistor array panel including a thin film transistor at various manufacturing stages, according to exemplary embodiments.

Referring to FIG. 27, after sequentially forming a gate electrode 124 and a gate insulating layer 140 on a substrate 110, a polysilicon or oxide semiconductor material is deposited to form a semiconductor layer 150, as seen in FIG. 13. The semiconductor layer 150 is patterned to form an island-type semiconductor 154, as seen in FIG. 27.

Adverting to FIG. 28, an inorganic material, such as, for instance, SiOx, SiNx, SiOC, SiON, etc., and/or an organic material is deposited on the semiconductor 154 via, for example, chemical vapor deposition. In this manner, the deposited layer is patterned to form an etch stopper 155.

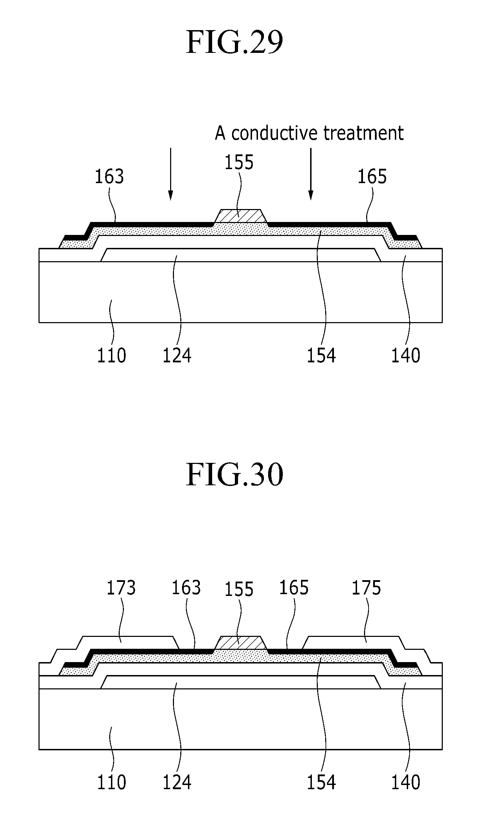

As seen in FIG. 29, a conductive treatment is performed in association with the portion of the semiconductor 154 that is not covered by the etch stopper 155. In this manner, the exposed surface subject to the conductive treatment forms the conductive layers 163 and 165 having conductivity. As previously described, when the semiconductor 154 includes an oxide semiconductor, the conductive treatment may include a plasma treatment. When the semiconductor 154 includes a polysilicon material, the conductive treatment to form the conductive layers 163 and 165 may include doping and annealing processes of an n-type impurity or a p-type impurity according to ion implantation. Any other suitable formation process, however, may be utilized to form the conductive layers 163 and 165.

With reference to FIG. 30, a conductive material, such as a conductive metal, is deposited on the conductive layer 160. The deposited conductive material is patterned to form the source electrode 173 and the drain electrode 175, which face each other with respect to the channel of the TFT. The source electrode 173 and the drain electrode 175 may not overlap and/or may be separate from the etch stopper 155. It is also contemplated that at least one of the source electrode 173 and drain electrode 175 may overlap the etch stopper 155.

As seen in FIG. 8, an inorganic and/or organic insulating material is deposited on the source electrode 173, the drain electrode 175, and the etch stopper 155 to form a passivation layer 180.

While certain exemplary embodiments and implementations have been described herein, other embodiments and modifications will be apparent from this description. Accordingly, the invention is not limited to such embodiments, but rather to the broader scope of the presented claims and various obvious modifications and equivalent arrangements.

**Claims**

1. A thin film transistor, comprising:

   a gate electrode;
   a gate insulating layer disposed on the gate electrode;
   a semiconductor disposed on the gate insulating layer;
   an etch stopper disposed on a channel of the semiconductor;
   a source electrode disposed on the semiconductor; and
   a drain electrode disposed on the semiconductor,
   wherein at least one of the source electrode and the drain electrode does not overlap with the etch stopper, and
   wherein at least one dimension of the etch stopper and the channel of the semiconductor are substantially the same.

2. The thin film transistor of claim 1, further comprising:

   a conductive layer disposed directly on a first portion of the semiconductor not covered by the etch stopper,
   wherein the conductive layer is electrically connected to the source electrode or the drain electrode.

3. The thin film transistor of claim 2, wherein the at least one of the source electrode and the drain electrode that does not overlap with the etch stopper is spaced away from the etch stopper and does not overlap with a second portion of the semiconductor.

4. The thin film transistor of claim 3, wherein the conductive layer is at least disposed directly on the second portion of semiconductor.

5. The thin film transistor of claim 4, wherein the conductive layer further comprises:

a portion disposed between the semiconductor and the source electrode or the drain electrode.

6. The thin film transistor of claim 5, wherein the semiconductor comprises a polysilicon or an oxide semiconductor material.

7. The thin film transistor of claim 2, wherein the conductive layer comprises a portion disposed between the semiconductor and the source electrode or the drain electrode.

8. The thin film transistor of claim 7, wherein the semiconductor comprises a polysilicon or an oxide semiconductor material.

9. A thin film transistor, comprising:

a gate electrode;
a gate insulating layer disposed on the gate electrode;
a semiconductor disposed on the gate insulating layer;
an etch stopper disposed on a channel of the semiconductor;
a source electrode disposed on the semiconductor;
a drain electrode disposed on the semiconductor; and
a conductive layer disposed directly on a first portion of the semiconductor that is not covered by the etch stopper, wherein the conductive layer is electrically connected to the source electrode or the drain electrode, and wherein at least one dimension of the etch stopper and the channel of the semiconductor are substantially the same.

10. The thin film transistor of claim 9, wherein the at least one of the source electrode and the drain electrode that does not overlap with the etch stopper is spaced away from the etch stopper and does not overlap with a second portion of the semiconductor.

11. The thin film transistor of claim 10, wherein the conductive layer comprises a first portion disposed directly on the second portion of the semiconductor.

12. The thin film transistor of claim 11, wherein the conductive layer further comprises:

a second portion disposed between the semiconductor and the source electrode or the drain electrode.

13. The thin film transistor of claim 12, wherein the semiconductor comprises a polysilicon or oxide semiconductor material.

14. The thin film transistor of claim 9, wherein the conductive layer comprises a portion disposed between the semiconductor and the source electrode or the drain electrode.

15. The thin film transistor of claim 14, wherein the semiconductor comprises a polysilicon or an oxide semiconductor material.

# FIG.1

# FIG.2

173    163    L    165    175    180

110    124    155    154    140

→ D1

# FIG.3

173    163    L    175    180

110    124    155    154    140

→ D1

# FIG.4

# FIG.5

# FIG.6

# FIG.7

# FIG.8

173    163    L    165    175    180

110    124    155    154    140

→ D1

# FIG.9

173    163    L    165    175    180

110    124    155    154    140

→ D1

# FIG.10

# FIG.11

# FIG.12

# FIG.13

110    124                150        140

# FIG.14

155

110    124                150        140

# FIG.15

155   170

110   124   150   140

# FIG.16

173   155   175

110   124   154   140

# FIG.17

A conductive treatment

173    163    165    175

110    124    155    154    140

# FIG.18

110  124  154  140

# FIG.19

155

110  124  154  140

# FIG.20

155      170

110    124       154    140

# FIG.21

173     155     175

110    124       154    140

EP 2 770 536 A1

# FIG.22

A conductive treatment

173  163        165  175

110  124  155  154  140

25

# FIG.23

155

110    124              150        140

# FIG.24

A conductive treatment

160              155              160

110    124              150        140

# FIG.25

155    160    170

110    124    150    140

# FIG.26

173    163    155    165    175

110    124    154    140

# FIG.27

110    124                    154        140

# FIG.28

155

110    124                    154        140

# FIG.29

A conductive treatment

163    155    165

110    124    154    140

# FIG.30

173    163    155    165    175

110    124    154    140

**EUROPEAN SEARCH REPORT**

Europäisches
Patentamt
European
Patent Office
Office européen
des brevets

Application Number

EP 13 16 9952

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/095288 A1 (MOROSAWA NARIHIRO [JP] ET AL) 28 April 2011 (2011-04-28) * paragraph [0070] - paragraph [0073]; figures 11,12 * ----- | 1-4,9-11 | INV. H01L29/417 H01L29/786 |
| X | US 5 712 494 A (AKIYAMA MASAHIKO [JP] ET AL) 27 January 1998 (1998-01-27) * the whole document * ----- | 1-15 | |
| X | US 2006/046335 A1 (SARMA KALLURI R [US] ET AL) 2 March 2006 (2006-03-02) * paragraph [0030] - paragraph [0047]; figures 4-10 * ----- | 1-15 | |
| A | EP 2 447 999 A1 (APPLIED MATERIALS INC [US]) 2 May 2012 (2012-05-02) * the whole document * ----- | 1-15 | |

TECHNICAL FIELDS
SEARCHED        (IPC)

H01L

The present search report has been drawn up for all claims

| Place of search | Date of completion of the search | Examiner |
|---|---|---|
| Berlin | 13 May 2014 | Hoffmann, Niels |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 16 9952

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2014

| Patent document cited in search report | | Publication date | Patent family member(s) | | Publication date |
|---|---|---|---|---|---|
| US 2011095288 | A1 | 28-04-2011 | CN | 102084486 A | 01-06-2011 |
| | | | JP | 2010016163 A | 21-01-2010 |
| | | | KR | 20110025768 A | 11-03-2011 |
| | | | US | 2011095288 A1 | 28-04-2011 |
| | | | WO | 2010001783 A1 | 07-01-2010 |
| US 5712494 | A | 27-01-1998 | JP | H08264790 A | 11-10-1996 |
| | | | US | 5712494 A | 27-01-1998 |
| US 2006046335 | A1 | 02-03-2006 | JP | 5128947 B2 | 23-01-2013 |
| | | | JP | 2008511999 A | 17-04-2008 |
| | | | KR | 20070061558 A | 13-06-2007 |
| | | | US | 2006046335 A1 | 02-03-2006 |
| | | | WO | 2006028811 A2 | 16-03-2006 |
| EP 2447999 | A1 | 02-05-2012 | CN | 103201839 A | 10-07-2013 |
| | | | EP | 2447999 A1 | 02-05-2012 |
| | | | JP | 2014502038 A | 23-01-2014 |
| | | | TW | 201234481 A | 16-08-2012 |
| | | | US | 2012104616 A1 | 03-05-2012 |
| | | | WO | 2012055728 A1 | 03-05-2012 |

EPO FORM P0459

For more details about this annex : see Official Journal of the European Patent Office, No. 12/82